Europäisches Patentamt

European Patent Office

Office européen des brevets

(11) Publication number: **0 074 793**
**B1**

# EUROPEAN PATENT SPECIFICATION

(45) Date of publication of patent specification: **03.07.85**

(21) Application number: **82304712.1**

(22) Date of filing: **08.09.82**

(51) Int. Cl.⁴: **H 03 L 7/08**, G 11 B 5/09, H 04 L 7/00

(54) **Phase-locked loop circuit.**

(30) Priority: **08.09.81 JP 141554/81**

(43) Date of publication of application:
**23.03.83 Bulletin 83/12**

(45) Publication of the grant of the patent:
**03.07.85 Bulletin 85/27**

(84) Designated Contracting States:
**DE FR GB**

(56) References cited:
**EP-A-0 009 939**
**DE-B-2 702 047**
**GB-A-2 067 372**
**US-A-3 950 658**

**HORST GESCHWINDE "Einführung in die PLL-Technik", 2nd edition, 1980, FRIEDRICH VIEWEG & SOHN Verlagsgesellschaft m.b.H., Braunschweig/Wiesbaden, page 124**

(73) Proprietor: **FUJITSU LIMITED**
**1015, Kamikodanaka Nakahara-ku**
**Kawasaki-shi Kanagawa 211 (JP)**

(72) Inventor: **Okada, Toshiro**
**20-3, Nakamachi 2-chome**
**Machida-shi Tokyo 194 (JP)**

(74) Representative: **Fane, Christopher Robin King et al**
**HASELTINE LAKE & CO. Hazlitt House 28 Southampton Buildings Chancery Lane London, WC2A 1AT (GB)**

## Description

The present invention relates to a phase-locked loop (PLL) circuit. A PLL circuit can be used for regenerating a synchronizing signal necessary for demodulation of a read signal of a magnetic disc device or the like in a data processing system.

In magnetic recording of digital data in a magnetic disc device or the like, a synchronous field is detected according to a hard format system of mechanical slits or the like or according to a soft format system of bit patterns of read data.

In the latter system, recorded data is detected as an analog signal and amplified by a magnetic head. The amplified analog waveform is converted to digital signals and then demodulated. Sampling data "1" and "0" are read out by synchronizing clock signals extracted from the data. In this case, a PLL circuit is ordinarily used to form synchronizing signals from the converted digital signals.

In the input data in the PLL circuit of the magnetic disc, before or after each data, a series of, for example, 48 bits of "0", is reached in the head portion of data subsequent to a front gap field GAP. This series of bits "0" contains no information bit. In actuality, this field is a synchronous field SYN including synchronizing bits alone without data bits. The subsequent data field read data (RDATA) includes synchronizing bits and data bits. Accordingly, if the PLL circuit is actuated to draw in a synchronizing lock by SYN preceding RDATA, and the PLL circuit is once locked, synchronous retention is maintained with the same repeated frequency by RDATA comprising the subsequent synchronizing bits and intermediate data bits. Therefore, while RDATA is continued, clock signals synchronous with synchronizing bits + data bits are always obtained from the output of the PLL circuit. When maximum data bits are intermediately inserted, RDATA has a frequency 2 times as high as that of SYN.

Even when the phase of the data bits in RDATA to be inputted to the PLL circuit is confused, synchronizing clock signals are generated without fail if within the lock range of the PLL circuit. The input pulses to the PLL circuit include regular synchronizing bits together with data bits varying according to the content of the information, so the momentary pulse repetition frequency of the input also varies and vacant portions occur irregularly. During such a vacant portion, the preceding comparison voltage supplied by the voltage control oscillator VCO performing comparison of the phases is retained and oscillation is maintained with a frequency corresponding to this voltage.

When the magnetic head starts the reading operation, no synchronizing signal is obtained. Accordingly, the reading operation is started at an arbitrary position of input data. Therefore, the PLL circuit according to the soft format system should be provided with a function of detecting SYN and starting the synchronizing operation.

The PLL circuit according to the soft format system can be effectively used when the normal synchronizing operation is performed in SYN in the state where the frequency and phase of the synchronizing bits are stable, and this normal synchronizing operation is maintained on the basis of the combined synchronizing bits and data bits in the subsequent DATA portion. Such a PLL circuit is known from EP—A1—0009939, for example.

However, when variations are caused in the frequency and phase by, for example, changes of the rotation speed of a magnetic recording member on reading of the SYN, so-called abnormal locking, that is, synchronization with a signal having a frequency other than the desired frequency may be caused. This is a defect of a conventional PLL circuit.

It is desirable to provide a PLL circuit which can be stably used even with variations of the frequency and phase in the input data.

According to the present invention there is provided a phase-locked loop circuit, for providing an output signal which is maintained in a predetermined desired phase relationship with a constant-frequency synchronizing component of an input signal including a head portion, consisting of the synchronizing component alone, followed by a data signal portion in which the synchronizing component is present together with data components, which circuit comprises:

a variable-frequency oscillator the operating frequency of which is dependent upon an input control signal; and a phase comparator, connected to operate during said data signal portion of said input signal, for varying such input control signal, in dependence upon phase difference between said synchronizing component and a synchronizing signal derived from said variable-frequency oscillator, so as to maintain a preselected phase relationship between the said synchronizing signal and said synchronizing component; characterized by;

preliminary synchronizing circuitry, including a frequency/phase comparator, arranged and connected to operate during said head portion of said input signal in such a manner as to vary the said input control signal, in dependence upon both phase difference and frequency difference between said synchronizing component and a synchronizing signal derived from said variable frequency oscillator, so as to achieve a preselected phase relationship between that synchronizing signal and said synchronizing component and so as to reduce such frequency difference.

Reference will now be made, by way of example, to the accompanying drawings, in which;

Figure 1 is a diagram illustrating the input data format in a PLL circuit of a magnetic disc;

Figure 2A is a block diagram of a conventional PLL circuit, and Figure 2B is a diagram illustrating the operation of a counter in the block diagram shown in Figure 2A.

Figure 3A is a block diagram of a phase comparator in Figure 2A and Figure 3B is a diagram illustrating the operation of the phase comparator in Figure 3A;

Figure 4 is a diagram illustrating the input data format and the relation between the output of the counter and the VCO output in a conventional PLL circuit;

Fig. 5 is a block diagram illustrating one embodiment a PLL circuit according to the present invention;

Fig. 6A is a block diagram of a frequency phase comparator shown in Fig. 5, and Fig. 6B is a diagram illustrating the operation of the frequency phase comparator shown in Fig. 6A;

Fig. 7A is a block diagram of a synchronous pattern detector included in the block diagram shown in Fig. 5; and Fig. 7B is a diagram illustrating the operation of the synchronous pattern detector shown in Fig. 7A; and

Fig. 8A is a block diagram illustrating another embodiment of a PLL circuit according to the present invention, and Fig. 8B is a diagram illustrating the operation of the PLL circuit shown in Fig. 8A.

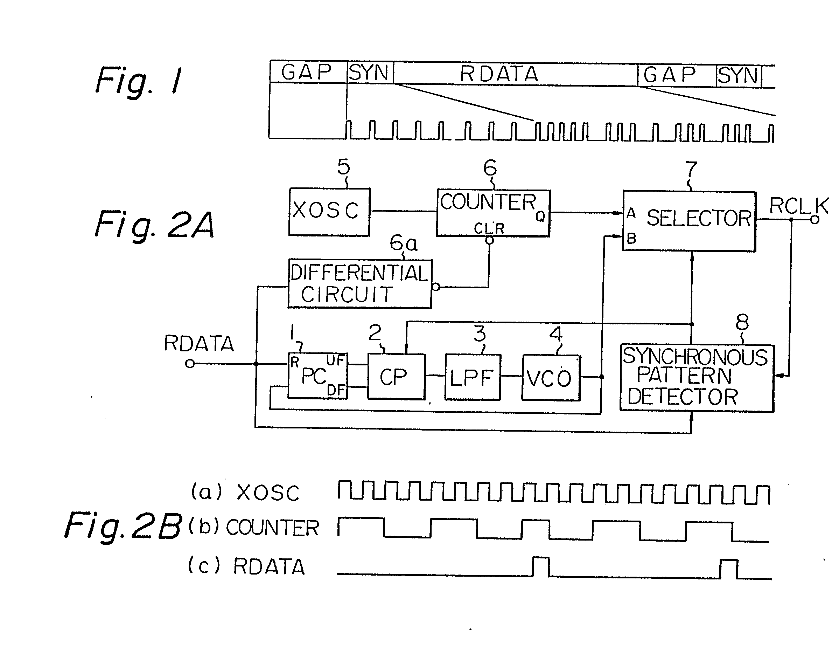

In the input data in the PLL circuit of the magnetic disc, shown in Fig. 1, before or after each data, a series of, for example, 48 bits of "0" is recorded in the head portion of data subsequent to a front gap field GAP. This series of bits "0" contains no information bit. Practically, this field is a synchronous field SYN including synchronizing bits alone without data bits, as described hereinafter. The subsequent data field RDATA comprises synchronizing bits and data bits. Accordingly, if the PLL circuit is actuated to draw in a synchronizing lock by SYN preceding RDATA and the PLL circuit is once locked, synchronous retention is maintained with the same repeated frequency by RDATA comprising the subsequent synchronizing bits and intermediate bits. Therefore, while RDATA is continued, clock signals synchronous with the synchronizing bits + data bits are always obtained from the outlet of the PLL circuit. When maximum data bits are intermediately inserted, RDATA has a frequency 2 times as high as that of SYN.

Figure 2A is a block diagram illustrating a conventional PLL circuit. In Fig. 2A, reference numerals 1, 2, 3, 4, 5, 6, 6a, 7 and 8 represent a phase comparator PC, a charge pump CP, a low pass filter LPF, a voltage control oscillator VCO, a crystal oscillator XOSC, an n-number system counter, a differential circuit, a selector, and a synchronous pattern detector, respectively.

A PLL circuit of the so-called counter-reset system is constructed by XOSC 5, the counter 6, and the differential circuit 6a. This circuit is characterized in that an abnormal lock is not generated, but since the resistance to jitter is not strong, the circuit is not suitable for reading an irregular data portion.

Figure 2B shows waveforms of the counter 6. As is seen from Fig. 2B, XOSC 5 oscillates with a frequency (a), for example, 2n times the frequency of synchronizing bits, and emits signals to the counter 6. Every time the n-number system counter 6 counts n of signals from XOSC 5, the counter 6 emits an output signal (b) to the selector. At the time of starting the reading operation, the synchronous pattern detector 8 puts out "0" as an off signal to cause the selector 7 to select an input A and to render CP disable. The selector 7 feeds out the input signal from the counter 6 as regenerating clock signals RCLK for the PLL circuit. The free running frequency of VCO 4 and the oscillating frequency of XOSC 5 in the state searching for the SYN field are made equal to the frequency of RCLK or an integer the number of times the frequency of RCLK, so that the synchronous locking can be performed at the time of the operation of the PLL circuit easily as a high synchronous response speed.

When the reading of DATA is started, the signal RDATA shown in Fig. 2B (c) is put in a clear terminal CLR of the counter 6 through the differential circuit 6a to reset the counting operation and effect synchronization. During this period, VCO make a free running oscillation.

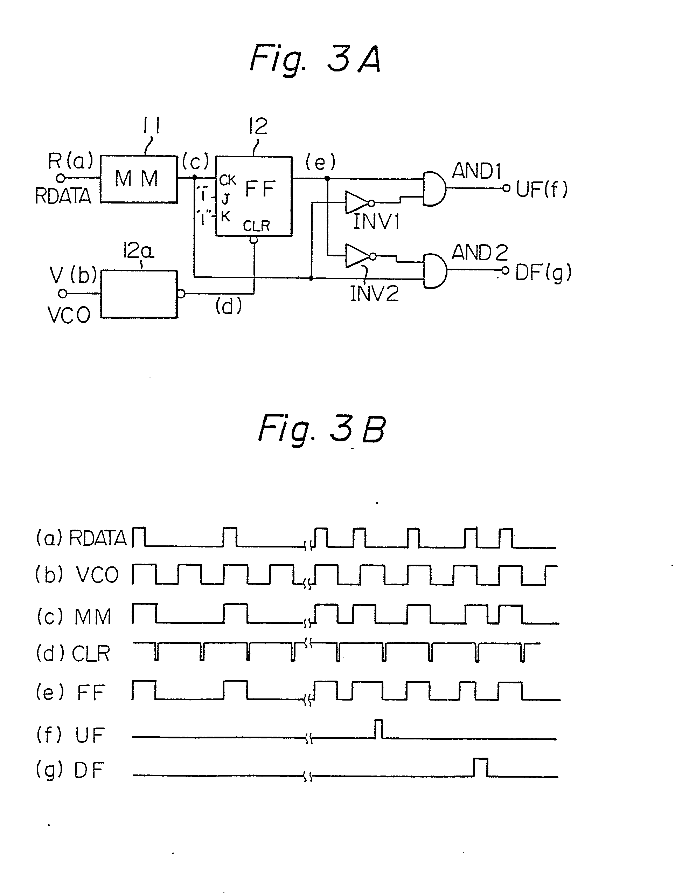

The synchronous pattern detector 8 utilizes the property of the synchronizing bits present in RDATA in the SYN region of having a frequency corresponding to 1/2 of the expected frequency of RCLK and of being continuative. When the logical sum is realized between 1/2 of the frquency of RCLK and the frequency of RDATA and a predetermined number of continuous bits, for example, 8 to 16 bits, are counted, the synchronous pattern detector 8 emits "1" as a synchronous pattern discrimination signal to the selector 7. At this point, the selector 7 selects a terminal B and simultaneously, it renders CP enable. As shown in Figs. 3A and 3B, which are a block diagram and an operation graph of PC 1, RDATA (a) is inputted to terminal R and is compared with a VCO signal (b) applied to a terminal V from VCO 4. RDATA inputted to the terminal R is adjusted as shown in Fig. 3B (c) in pulses to a width corresponding to about 1/2 of the frequency of the VCO signal by a monostable multivibrator (MM) 11 and is inputted as an MM signal shown in Fig. 3B (c) to a clock terminal CK of a flip-flop circuit (FF) 12. The VCO signal is inputted to CLR of FF 12 through the differential circuit 12a to reset FF as shown in Fig. 3B (d). The output signal (e) of FF 12 is compared with the MM signal and when the difference between both the signals is detected by a NOT circuit (INV) 1, 2 and an AND circuit (AND) 1, 2, the VCO signal is outputted as a pump-up signal UF (f), for correcting a delay with respect to RDATA, or a pump-down signal DF (g), for correcting an advance with respect to RDATA, from the respective terminals. The difference signal UF or DF corresponding to the detected phase difference is converted to a voltage proportional to the difference signal in CP 2. Noises and high-frequency components are removed from the voltage by LPF 3, and the voltage is applied to the control terminal of VCO 4. Incidentally, LPF 3 has an integrating function to maintain the voltage during the period corresponding to the vacant portion of RDATA. VCO 4 is linearly controlled by the control signal from CP 2, which is proportional to the phase difference, so that the phase difference between both the input signals of PC 1 is diminished, whereby the phase (frequency) is changed. For example, if the synchronizing bits in SYN are sufficiently close to 1/2 of the frequency of VCO, the VCO signal locks the synchronizing bits alternately, and the phase difference of the locked bits from 1/2 of the frequency of VCO becomes zero. Thus, the ouput signal of VCO 4 synchronous with RDATA is outputted as RCLK.

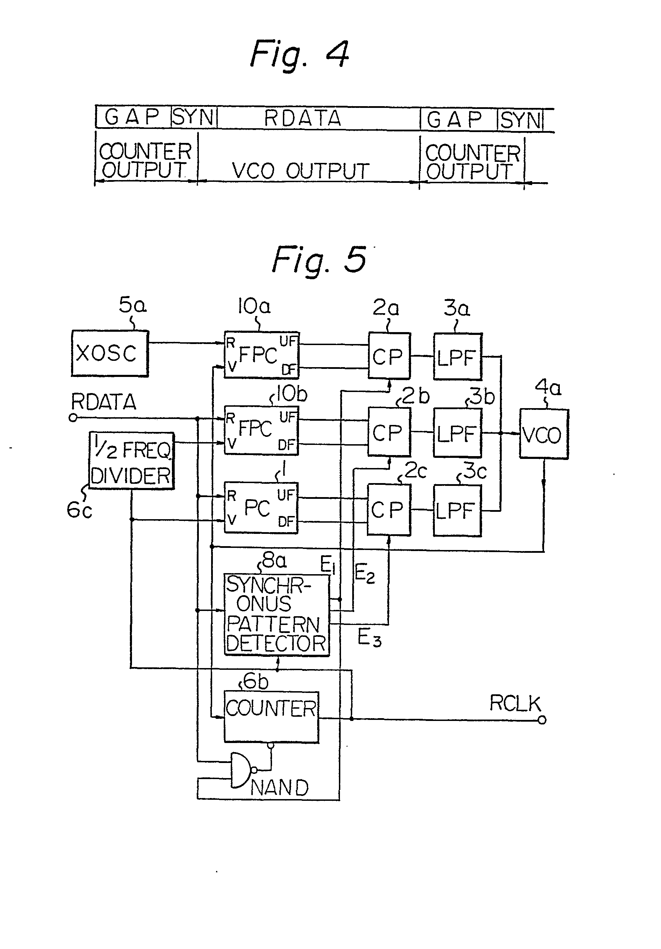

Figure 4 shows the comparison of the RDATA format with the outputs of the counter and VCO.

As is apparent from the foregoing description, PC 1 detects the phase difference only with respect to the portion where the MM and VCO signals overlap each other, as shown in Fig. 3B. PC 1 does not perform any detecting action when one of the two signals is not present or there is a phase difference exceeding ±180°. In this case, the difference signal UF or DF corresponding to the phase difference between the above two signals is not outputted. Accordingly, although the conventional PLL circuit is suitable for RDATA including a vacant portion, synchronous locking at a frequency other than the desired frequency can take place.

In the conventional system resetting the counter and utilizing the phase comparator, in the case where the normal synchronizing operation is performed in SYN in the state where the frequency and phase of the synchronizing bits are stable, this normal synchronizing operation is held by (synchronizing bits + data bits) in the subsequent DATA portion, and no trouble is caused.

However, when variations are caused in the frequency and phase by, for example, changes of the rotation speed of a magnetic recording member on reading of SYN, so-called abnormal locking, that is, synchronization with a signal having a frequency other than the desired frequency, can occur. This is a defect of the PLL circuit.

In an embodiment of the invention, frequency phase comparators are inserted between the conventional counter lock and phase comparator and they are changed over so that a frequency phase comparator having a broad draw-in range is used for the synchronizing operation in the synchronous introduction portion, whereby a stable PPL circuit that can advantageously be used for a magnetic disc or the like can be constructed.

Figure 5 is a block diagram illustrating a PLL circuit according to one embodiment of the present invention. Reference numeral 1 represents a phase comparator, each of reference numerals 2a, 2b and 2c represents a charge pump CP; each of reference numerals 3a, 3b, and 3c represents a low pass filter LPF; reference numeral 4a represents a voltage controlled oscillator VCO; reference numeral 5a represents a crystal oscillator XOSC; reference numeral 6b represents a counter; reference numeral 6c represents a 1/2 divider; reference numeral 8a represents a synchronous pattern detector; NAND represents a NAND circuit; and each of reference numerals 10a and 10b represents a frequency phase comparator for use in preliminary synchronization.

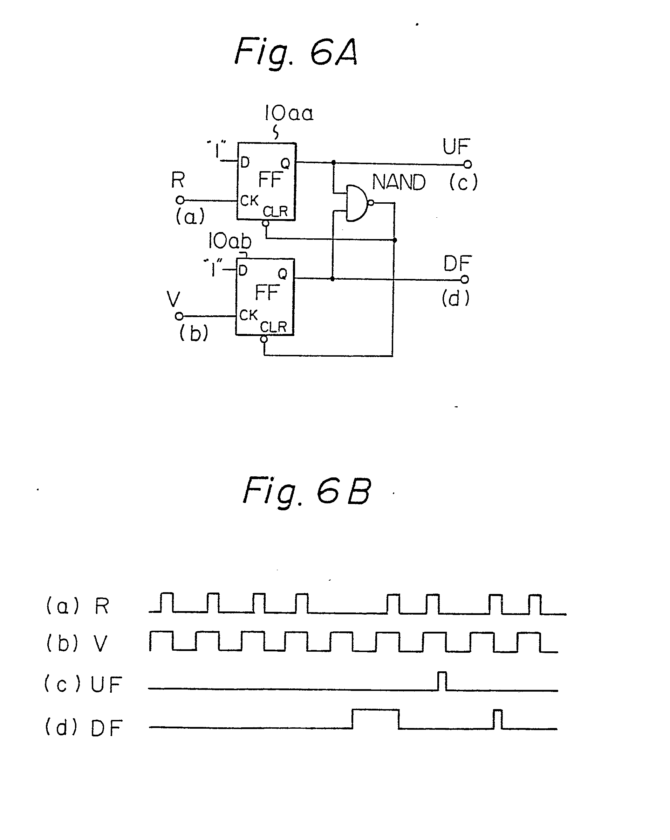

PC 1, LPF 3c, and VCO 4a have the same functions as in the conventional circuit. As shown in the block diagram of Fig. 6a, FPC 10a and 10b comprise flip-flops 10aa and 10ab and a NAND circuit NAND.

Like the phase comparator PC in the conventional circuit of Figure 2a, the frequency/phase comparator FPC 10b in the circuit of Figure 5 delivers pump-up and pump-down signals UF and DF as needed to correct detected phase deviations of the VCO output signal with respect to RDATA. Additionally, however, FPC 10b also detects frequency deviations and delivers signals UF and DF when the frequency of the VCO output signal is found to be respectively lower and higher than that of RDATA. Further, FPC 10b delivers the signal DF during a vacant portion of RDATA. Such operation is illustrated in Figure 6B.

Frequency/phase comparator FPC 10a operates similarly to FPC 10b but on the basis of comparison with the reference signal from XOSC 5a instead of with RDATA.

Accordingly, EPC 10a and 10b have not only the phase-comparing function possessed by PC 1 but also a frequency-comparing function, and the synchronizing range is thereby broadened.

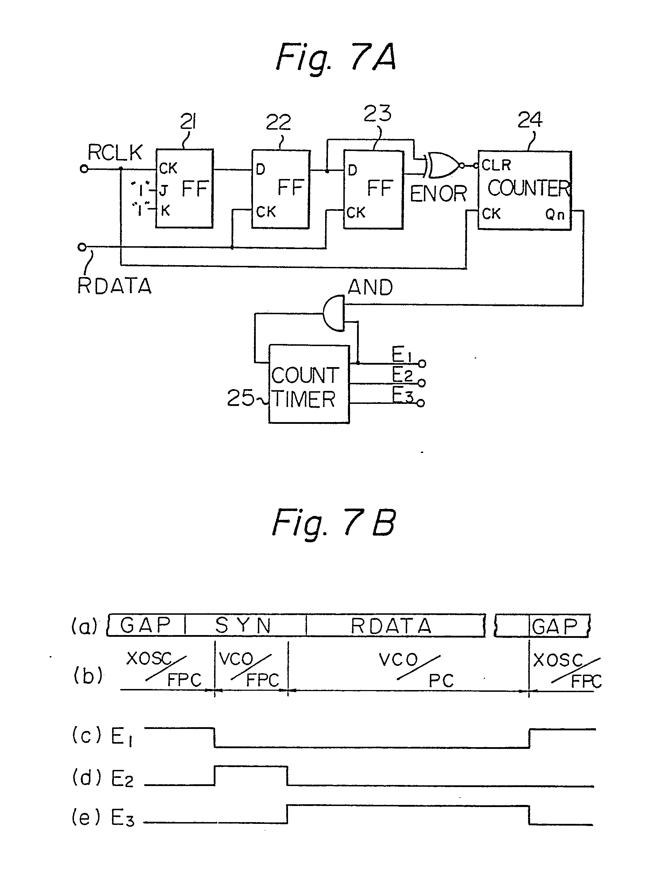

As shown in the block diagram of Figure 7a, the synchronous pattern detector 8a comprises flip-flops 21, 22 and 23, a n-number system counter 24, a count timer 25, an exclusive negative OR circuit ENOR and an AND circuit AND. As in the conventional circuit, the synchronous pattern detector detects SYN in the head portion of RDATA, as illustrated in the waveforms shown in Figure 7B. When 16 (for example) successive synchronizing bits are recognized, the counter 24 puts out a signal from Qn to turn off the output E1 of the count timer 25 to "0". Simultaneously, the count timer 25 turns on the output E2 which is then held on during the period from the 16th bit to the 32nd bit. The output E3 is then turned on, and is held on during the effective region of RDATA beginning from the 32nd bit, that is, while data bits continue. When RDATA has passed, the count timer 25 turns off the output E3 and turns on the output E1 again.

In the embodiment of the present invention having the above-mentioned block structure, in the portion GAP of RDATA, the synchronous pattern detector 8a puts out E1 and thus selects CP 2a, thereby rendering effective a comparison of the signal from XOSC 5a with the output signal of VCO 4. According to the operation of EPC 10a, VCO 4a is synchronized and locked anda regenerating clock signal RCLK is put out through the 8-number system counter 6b. Accordingly, the frequency ratio of VCO 4a and XOSC to RCLK is 8:1.

When RDATA arrives and the SYN field appears, and when 16 synchronizing bits have been counted by the synchronous pattern detector 8a, E1 is replaced by E2, and CP 2b is thus selected so that FPC 10b takes over the synchronization of VCO 4a, comparing the frequency and phase of the synchronizing bits of the SYN field with a signal derived from the output of VCO 4a by means of the 1/2 divider 6c. Accordingly, the frequency of the VCO signal is hardly changed, but VCO 4a is synchronized and locked by FPC 10b, RCLK being delivered through the counter 6c.

When 32 synchronizing bits have been counted by the synchronous pattern detector 8a, E2 is replaced by E3, and CP 2c is thus selected. The synchronizing lock is transferred to PC 1 which effects a pulse comparison between RDATA.

As seen from the foregoing description, the signal from VCO 4a is synchronized and locked by selecting in sequence the output signal of FPC 10a, working on the basis of the signal from XOSC 5a, the frequency/phase synchronizing signal from FPC 10b (using the synchronizing bits in the SYN region of RDATA), and finally the signal of PC 1 (using the synchronizing bits in the RDATA portion). Individual disadvantages that could be experienced if either of the comparators FPC 10b and PC 1 were used alone can thus be avoided by using both comparators in sequence. Even when variations occur in the synchronizing bits in the SYN region, synchronization of the frequency can be accomplished by FPC 10b. Synchronization of the frequency is performed in the RDATA portion by PC 1 which is effective for stabilizing the VCO output signal during vacant portions of RDATA. Thus, there can be provided a valuable PLL circuit in which synchronizing signals necessary for reading magnetic records are effectively regenerated with a high reliability against variations in the portion SYN.

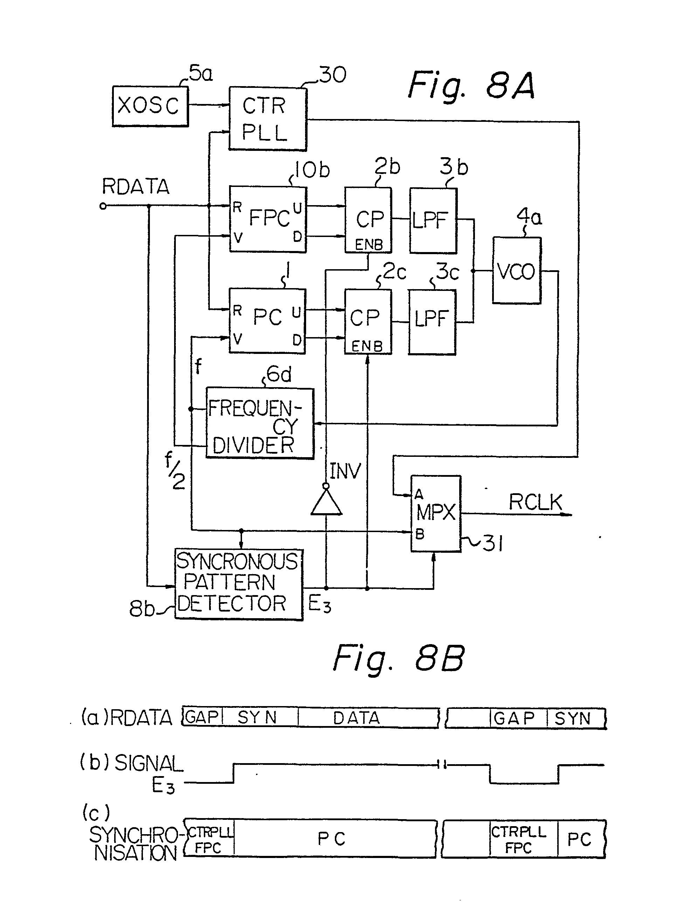

Figure 8A shows a block diagram of another embodiment of the present invention. In Figure 8A, the reference numerals the same as in Figure 5 represent members with the same function. In Figure 8a, reference numeral 30 represents a counter reset type phase synchronizer, 8b denotes a synchronous pattern detector and 31 denotes a selector. The counter reset type phase synchronizer 30 is a phase comparator formed by multivibrators, flip-flop circuits, and a logic circuit. The counter reset type synchronizer includes no analog circuit. The output of this synchronizer 30 is connected to a terminal A of the selector 31. A terminal B of the selector 31 receives the output f of the frequency divider 6d. The synchronous pattern detector 8b generates a selection signal $E_3$ at a predetermined position in the synchronizing portion SYN as shown in Figure 8B (b). During the time when the synchronous pattern detector generates no selection signal $E_3$, the charge pump 2b connected to the frequency phase comparator is in the enable state. Therefore, the frequency phase comparator 10b is in an operative state when the output of the synchronizer 30 is selected at the terminal A of the selector 31 so that the output frequency of the voltage controlled oscillator 4a is precisely corresponded to the synchronizing bit. That is, as shown in Figure 8B (c), when the selection signal $E_3$ is not generated, the synchronizer 30 and the frequency phase comparator 10b are in the operative state. When the selection signal is generated, the phase comparator 1 enters the operative state, so that the synchronous pattern detector 8b can be simplified.

Thus there can be provided a PLL circuit which obtains a signal synchronized with a phase of an input signal having a synchronizing signal portion formed by a constant frequency signal and a data signal portion formed by a non-constant frequency.

**Claims**

1. A phase-locked loop circuit, for providing an output signal which is maintained in a predetermined desired phase relationship with a constant-frequency synchronizing component of an input signal including a head portion, consisting of the synchronizing component alone, followed by a data signal portion in which the synchronizing component is present together with data components, which circuit comprises:
a variable-frequency oscillator (VCO) the operating frequency of which is dependent upon an input control signal; and a phase comparator (PC), connected to operate during said data signal portion of said input signal, for varying such input control signal, in dependence upon phase difference between said synchronizing component and a synchronizing signal derived from said variable-frequency oscillator, so as to maintain a preselected phase relationship between the said synchronizing signal and said synchronizing component; characterized by;
preliminary synchronizing circuitry, including a frequency/phase comparator (FPC), arranged and connected to operate during said head portion of said input signal in such a manner as to vary the said input control signal, in dependence upon both phase difference and frequency difference between said synchronizing component and a synchronizing signal derived from said variable frequency oscillator, so as to achieve a preselected phase relationship between that synchronizing signal and said synchronizing component and so as to reduce such frequency difference.

2. A phase-locked loop circuit as claimed in claim 1, further comprising a reference frequency signal generator (XOSC), for generating a reference frequency signal, and auxiliary circuitry including an auxiliary frequency/phase comparator (FPC 10a) arranged and connected to operate during a gap period before the said head portion of the signal in such a manner as to vary the said input control signal, in dependence upon both phase difference and frequency difference between the said reference fequency signal and a synchronizing signal derived from the said variable frequency oscillator, so as to achieve a preselected phase relationship between that synchronizing signal and the reference frequency signal and so as to reduce such frequency difference.

3. A phase-locked loop circuit as claimed in claim 1, further comprising a reference frequency signal generator (XOSC), for generating a reference frequency signal, and auxiliary circuitry including an auxiliary phase comparator arranged and connected to operate in such a manner as to vary the said input control signal, in dependence upon phase difference between the said reference frequency signal and the said synchronizing component, so as to achieve a preselected phase relationship between the reference frequency and a synchronizing signal derived from the said variable frequency oscillator.

**Revendications**

1. Circuit de boucles à phase rigide, pour fournir un signal de sortie qui est maintenu dans un rapport de phase voulu prédéterminé avec une composante de synchronisation à fréquence constante d'un signal d'entrée incluant une partie en-tête, constituée par la composante de synchronisation seule, suivie d'une partie de signal de données dans laquelle la composante de synchronisation est présente avec les composantes de données, ce circuit comprenant:

un oscillateur à fréquence variable (VCO) dont la fréquence de fonctionnement est fonction d'un signal de commande d'entrée; et un comparateur de phases (PC), connecté pour fonctionner pendant la partie de signal de données du signal d'entrée, pour faire varier le signal de commande d'entrée, en fonction de la différence de phase entre la composante de synchronisation et un signal de synchronisation dérivé de l'oscillateur à fréquence variable, de manière à maintenir un rapport de phase présélectionné entre le signal de synchronisation et la composante de synchronisation; caractérisé par:

un circuit de synchronisation préliminaire, incluant un comparateur de fréquences/phases (FPC), agencé et connecté pour fonctionner pendant la partie en-tête du signal d'entrée de manière à faire varier le signal de commande d'entrée, en fonction de la différence de phase et de la différence de fréquence entre la composante de synchronisation et un signal de synchronisation dérivé de l'oscillateur à fréquence variable, de manière à obtenir un rapport de phase présélectionné entre le signal de synchronisation et la composante de synchronisation et à réduire cette différence de fréquence.

2. Circuit de boucles à phase rigide selon la revendication 1, caractérisé en ce qu'il comprend en outre un générateur de signal de fréquence de référence (XOSC), pour engendrer un signal de fréquence de référence, et un circuit auxiliaire incluant un comparateur de fréquences/phases (FPC 10a) agencé et connecté pour fonctionner pendant une période vide avant la partie en-tête du signal de manière à faire varier le signal de commande d'entrée, en fonction à la fois de la différence de phase et de la différence de fréquence entre le signal de fréquence de référence et un signal de synchronisation dérivé de l'oscillateur à fréquence variable, de manière à obtenir un rapport de phase présélectionné entre le signal de synchronisation et le signal de fréquence de référence et à réduire cette différence de fréquence.

3. Circuit de boucles à phase rigide selon la revendication 1, caractérisé en ce qu'il comprend en outre un générateur de signal de fréquence de référence (XOSC) pour engendrer un signal de fréquence de référence, et un circuit auxiliaire incluant un comparateur de fréquences/phases agencé et connecté pour fonctionner de manière à faire varier le signal de commande d'entrée, en fonction de la différence de phase entre le signal de fréquence de référence et la composante de synchronisation, de manière à obtenir un rapport de phase présélectionné entre la fréquence de référence et un signal de synchronisation dérivé de l'oscillateur à fréquence variable.

**Patentansprüche**

1. Phasenstarre Schleifenschaltung, zur Erzeugung eines Ausgangssignals, welches in einer vorbestimmten gewünschten Phasenrelation zu einer Synchronisierungskomponente konstanter Frequenz eines Eingangssignals gehalten wird, das einen Kopfteil umfaßt, der allein aus der Synchronisierungskomponente besteht, gefolgt von einem Datensignalabschnitt, in dem die Synchronisierungskomponente zusammen mit Datenkomponenten vorhanden ist, welche Schleifenschaltung umfaßt:

einen Oszillator (VCO) mit variabler Frequenz, dessen Betriebsfrequenz abhängig ist von einem Eingangssteuersignal; und einen Phasenkomparator (PC), der angeschlossen ist, um während des gennannten Datensignalabschnitts des genannten Eingangssignals zu arbeiten, um solch ein Eingangssteuersignal in Abhängigkeit von der Phasendifferenz zwischen der genannten Synchronisierungskomponente und einem Synchronisierungssignal zu variieren, das von dem genannten Oszillator variabler Frequenz abgeleitet wird, um so eine vorbestimmte Phasenrelation zwischen dem genannten Synchronisierungssignal und der genannten Synchronisierungskomponente aufrechtzuerhalten; gekennzeichnet durch;

eine vorsynchronisierende Schaltung, die einen Frequenz/Phasen-Komparator (FPC) umfaßt, der so angeordnet und angeschlossen ist, daß er während des genannten Kopfteils des genannten Eingangssignals auf solch eine Weise arbeitet, · daß er das genannte Eingangssteuersignal in Abhängigkeit von sowohl der Phasendifferenz als auch der Frequenzdifferenz zwischen der genannten Synchronisierungskomponente und einem Synchronisierungssignal variiert, welches von dem genannten Oszillator mit variabler Frequenz abgeleitet wird, um so eine vorausgewählte Phasenrelation zwischen diesem Synchronisierungssignal und der genannten Synchronisierungskomponente zu erreichen und um so eine solche Frequenzdifferenz zu reduzieren.

2. Phasenstarre Schleifenschaltung nach Anspruch 1, ferner gekennzeichnet durch einen Referenzfrequenzsignalgenerator (XOSC), zur Erzeugung eines Referenzfrequenzsignals, und durch eine Hilfsschaltung, welche einen Hilfsfrequenz/Phasen-Komparator (FPC 10a) umfaßt, der so angeordnet und angeschlossen ist, daß er während eines Zwischenraums vor dem genannten Kopfteil des Signals auf eine solche Weise arbeitet, daß er das Eingangssteuersignal variiert, in Abhängigkeit von sowohl der Phasendifferenz und der Frequenzdifferenz zwischen dem genannten Referenzfrequenzsignal und einem Synchronisierungssignal, welches von dem genannten Oszillator variabler Frequenz abgeleitet wird, um so eine vorausgewählte Phasenrelation zwischen diesem Synchronisierungssignal und dem Referenzfrequenzsignal zu erzielen und um so eine solche Frequenzdifferenz zu reduzieren.

3. Phasenstarre Schleifenschaltung nach Anspruch 1, ferner gekennzeichnet durch einen Referenzfrequenzsignalgenerator (XOSC), zur Erzeugung eines Referenzfrequenzsignals, und durch eine Hilfsschaltung, welche einen Hilfsfrequenz/Phasen-Komparator umfaßt, der so angeordnet und angeschlossen ist, daß er auf eine solche Weise arbeitet, um das genannte Eingangssteuersignal in Abhängigkeit von der Phasendifferenz zwischen dem genannten Referenzfrequenzsignal und der genannten Synchronisierungskomponente zu variieren, um so eine vorausgewählte Phasenrelation zwischen der Referenzfrequenz und einem Synchronisierungssignal, das von dem genannten Oszillator mit variabler Frequenz abgeleitet wird, zu erreichen.

Fig. 1

Fig. 2A

Fig. 2B (a) XOSC
(b) COUNTER
(c) RDATA

0 074 793

# Fig. 3A

# Fig. 3B

(a) RDATA

(b) VCO

(c) MM

(d) CLR

(e) FF

(f) UF

(g) DF

0 074 793

## Fig. 4

| G A P | SYN | R D A T A | G A P | SYN |
|---|---|---|---|---|
| COUNTER OUTPUT | | VCO OUTPUT | COUNTER OUTPUT | |

## Fig. 5

# Fig. 6A

# Fig. 6B

(a) R
(b) V
(c) UF
(d) DF

4

# Fig. 7A

# Fig. 7B

## Fig. 8A

## Fig. 8B

(a) RDATA | GAP | SYN | DATA | | GAP | SYN

(b) SIGNAL E₃

(c) SYNCHRO-NISATION | CTRPLL FPC | PC | | CTRPLL FPC | PC